# EUROPEAN PATENT APPLICATION

(11) **EP 4 371 810 A2**
(43) Date of publication of application: **22.05.2024**
(21) Application number: 23210060.2
(22) Date of filing: 15.11.2023
(51) Int. Cl.: B60L 53/80, B60L 3/00, G01R 31/00

(54) **TRACTION BATTERY SAMPLING ABNORMALITY RECOGNITION APPARATUS AND METHOD, AND BATTERY SWAP STATION**

(30) Priority: 17.11.2022 CN 202211442167
(71) Applicant: Nio Technology (Anhui) Co., Ltd, Hefei City, Anhui 230601 (CN)
(72) Inventor: LI, Jinxing, Hefei City, Anhui, 230601 (CN); ZHAO, Jianzhi, Hefei City, Anhui, 230601 (CN)
(74) Representative: Vossius & Partner Patentanwälte Rechtsanwälte mbB

(57) **Abstract**

The disclosure provides a traction battery sampling abnormality recognition apparatus, a traction battery sampling abnormality recognition method, and a battery swap station. The apparatus includes the following modules communicatively connected: a data obtaining module configured to obtain sampled data of a traction battery in a preset time window; a probability calculation module configured to obtain a fluctuation value between sampled data at adjacent moments, and calculate a probability of occurrence of a fluctuation value greater than a preset fluctuation value threshold in the preset time window; and a determining module configured to determine, based on the probability, whether the traction battery has a sampling abnormality, where if the probability is greater than a preset probability threshold, or the probability is less than the probability threshold and a change rate of the probability over time is greater than a preset change rate threshold, the determining module determines that the traction battery has a sampling abnormality. Through longitudinal comparison between the sampled data of the traction battery over time, impact of an external factor can be reduced, and abnormality recognition accuracy can be improved accordingly.

## Description

### Technical Field

The disclosure relates to an apparatus and a method for recognizing a sampling abnormality of a traction battery, and a battery swap station capable of performing such a method.

### Background Art

During use of a traction battery, for example, a lithium-ion battery, of a new energy vehicle, a related parameter of the traction battery including a related parameter at a traction battery level or a related parameter at a traction battery component level needs to be acquired in real time, so that a working status of the traction battery may be mastered in time, and the traction battery may be controlled based on the working status. The related parameter of the traction battery is acquired by an integrated battery management system (BMS).

As a life span of the traction battery increases, a probability that a sampling function of the traction battery fails may increase correspondingly. An information loss caused by a failure of the sampling function of the traction battery may cause misreporting of a failure of the traction battery, and may also bring safety problems such as overcharge and overdischarge of the battery and even an explosion in a severe case.

### Summary

According to different aspects, an objective of the disclosure is to provide an apparatus and a method for recognizing a sampling abnormality of a traction battery, and a battery swap station provided with such an apparatus.

In addition, the disclosure also aims to solve or alleviate other technical problems existing in the prior art.

To solve the above problems, the disclosure provides a traction battery sampling abnormality recognition apparatus, which specifically includes the following modules communicatively connected:
a data obtaining module configured to obtain sampled data of a traction battery in a preset time window;
a probability calculation module configured to obtain a fluctuation value between sampled data at adjacent moments, and calculate a probability of occurrence of a fluctuation value greater than a preset fluctuation value threshold in the preset time window; and
a determining module configured to determine, based on the probability, whether the traction battery has a sampling abnormality, wherein if the probability is greater than a preset probability threshold, or the probability is less than the probability threshold and a change rate of the probability over time is greater than a preset change rate threshold, the determining module determines that the traction battery has a sampling abnormality.

According to the traction battery sampling abnormality recognition apparatus proposed in an aspect of the disclosure, the apparatus further includes a probability threshold determining module configured to determine the probability threshold by using a statistical method, and transmit the probability threshold to the determining module.

According to the traction battery sampling abnormality recognition apparatus proposed in an aspect of the disclosure, the probability threshold determining module is configured to call historical sampled data of the traction battery, and determine the probability threshold based on the historical sampled data, or the probability threshold determining module is configured to call reference sampled data of a reference traction battery of a same type, and determine the probability threshold based on the reference sampled data.

According to the traction battery sampling abnormality recognition apparatus proposed in an aspect of the disclosure, the sampled data obtained by the data obtaining module carries overall information about the traction battery used as a whole or cell information about a cell of the traction battery.

According to the traction battery sampling abnormality recognition apparatus proposed in an aspect of the disclosure, the apparatus further includes a time window determining module configured to determine the preset time window based on a working status of the traction battery, and transmit the determined preset time window to the data obtaining module in a manner of a signal.

According to the traction battery sampling abnormality recognition apparatus proposed in an aspect of the disclosure, the time window determining module is configured to set a preset time window in a charging/discharging state of the traction battery to be smaller than that in a rest state of the traction battery.

According to the traction battery sampling abnormality recognition apparatus proposed in an aspect of the disclosure, the sampled data carries voltage information, temperature information, or current information.

According to the traction battery sampling abnormality recognition apparatus proposed in an aspect of the disclosure, the apparatus further includes an early warning module that is communicatively connected to the determining module and correspondingly sends an early warning signal when it is determined that the traction battery has a sampling abnormality.

According to another aspect of the disclosure, there is provided a traction battery sampling abnormality recognition method executable by such an apparatus, which includes steps of:
obtaining sampled data of a traction battery in a preset time window;
obtaining a fluctuation value between sampled data at adjacent moments in the preset time window, and calculating a probability of occurrence of a fluctuation value greater than a fluctuation value threshold in the preset time window; and
in response to the probability being greater than a probability threshold, or in response to the probability being less than the probability threshold and a change rate of the probability over time being greater than a change rate threshold, determining that the traction battery has a sampling abnormality.

According to the traction battery sampling abnormality recognition method proposed in another aspect of the disclosure, the probability threshold is obtained based on historical sampled data or reference sampled data by using a statistical method.

According to the traction battery sampling abnormality recognition method proposed in another aspect of the disclosure, the preset time window is set based on a working status of the traction battery, and a preset time window in a charging/discharging state of the traction battery is smaller than that in a rest state of the traction battery.

According to still another aspect of the disclosure, there is provided a battery swap station for performing a battery charging and swap operation on a traction battery. The above traction battery sampling abnormality recognition apparatus is disposed in the battery swap station or a cloud belonging to the battery swap station.

According to the battery swap station proposed in still another aspect of the disclosure, the battery swap station includes a storage unit configured to store related information of a traction battery already served, and the traction battery sampling abnormality recognition apparatus may call the related information as reference sampled data.

Through longitudinal comparison between the sampled data of the traction battery over time, the traction battery sampling abnormality recognition apparatus according to the disclosure can reduce impact of an external factor, and improve abnormality recognition accuracy accordingly.

### Brief Description of the Drawings

The above and other features of the disclosure will become apparent with reference to the accompany drawings, in which:
FIG. 1 is a schematic block diagram of a traction battery sampling abnormality recognition apparatus according to the disclosure; and
FIG. 2 is a flowchart of a traction battery sampling abnormality recognition method according to the disclosure.

### Detailed Description of Embodiments

It can be readily understood that according to the technical solution of the disclosure, a person of ordinary skill in the art may propose multiple interchangeable structures and implementations without changing the essential spirit of the disclosure. Therefore, the following specific embodiments and the accompanying drawings are merely exemplary descriptions of the technical solutions of the disclosure, and should not be construed as the entirety of the disclosure or construed as limiting the technical solution of the disclosure.

Orientation terms, such as up, down, left, right, front, rear, front side, back side, top, and bottom, which are or may be mentioned in this description, are defined with respect to the structures shown in the accompanying drawing, and are relative concepts, and therefore may correspondingly vary depending on different positions and different usage states. Therefore, these or other directional terms should not be explained as limiting terms. Moreover, the terms such as "first" "second", "third" or similar expressions are only used for description and distinction purposes, and should not be construed as indicating or implying the relative importance of corresponding members.

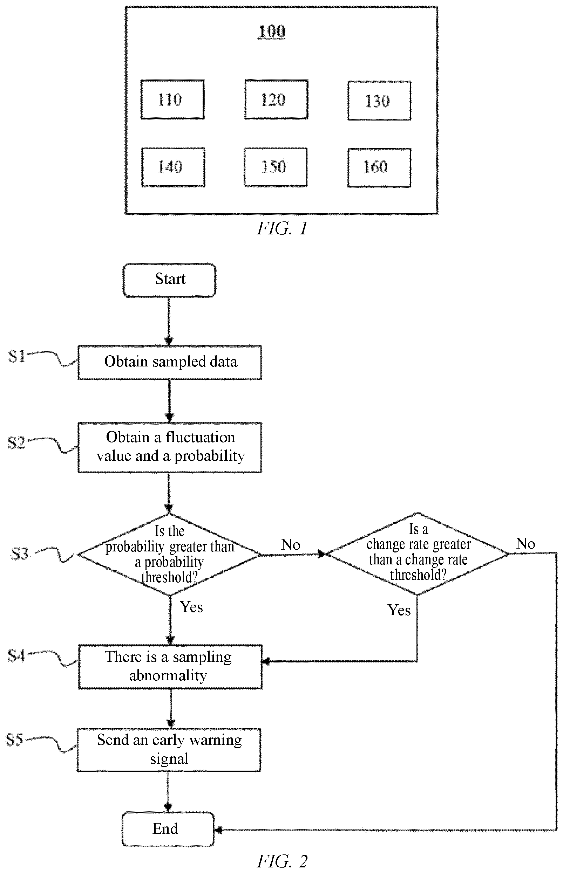

FIG. 1 is a block diagram of an implementation of a traction battery sampling recognition apparatus 100 according to the disclosure. The apparatus mainly includes a data obtaining module 110, a probability calculation module 120, and a determining module 130. The data obtaining module 110 may be communicatively connected to a BMS of a traction battery directly, to obtain sampled data for a preset time window. Alternatively, the data obtaining module 110 is connected to a vehicle bus, to obtain sampled data that is stored in the vehicle bus and that is acquired by a BMS. The probability calculation module 120 is configured to receive the obtained sampled data, and process the sampled data to learn a fluctuation of the sampled data. Specifically, the probability calculation module is configured to calculate a proportion of sampled data whose fluctuation degree does not conform to a standard. Mathematically, the probability calculation module 120 is configured to obtain a fluctuation value between sampled data at adjacent moments, and calculate a probability of occurrence of the fluctuation value being greater than a preset fluctuation value threshold in the preset time window. Then, the determining module 130 determines, based on the received probability, whether the traction battery satisfies a preset condition, and based on this, determines whether there is a sampling abnormality. Specifically, if the received probability exceeds a preset probability threshold, it is determined that the traction battery has a sampling abnormality. Alternatively, if a change rate of the received probability over time exceeds a preset change rate threshold, it is determined that the traction battery has a sampling abnormality. Herein, the change rate of the probability actually reflects a failure or aging of sampling hardware of the traction battery. This is because in a healthy state, the change rate of the probability is substantially stable or not so high in the preset time window.

Correspondingly, a traction battery sampling abnormality recognition method according to the disclosure performed by such an apparatus mainly includes the following steps:
S 1: obtaining sampled data of a traction battery in a preset time window by using the data obtaining module 110;
S2: obtaining a fluctuation value between sampled data at adjacent moments in the preset time window by using the probability calculation module 120, and calculating a probability of occurrence of a fluctuation value greater than a fluctuation value threshold in the preset time window; and
S3: comparing, in the determining module 130, the probability with a probability threshold, and comparing a change rate of the probability with a change rate threshold, where if the probability is greater than the probability threshold, or the probability is less than the probability threshold and the change rate of the probability over time is greater than the change rate threshold, step S4 is performed: determining that the traction battery has a sampling abnormality.

It should be first noted that in the disclosure, whether a sampling component of the traction battery (broadly speaking, a BMS of the traction battery) has a sampling abnormality is determined based on data from the sampling component. In addition, the disclosure aims to recognize a functional failure of sampling hardware of the traction battery. An abnormal case of inaccurate sampling is mainly involved. However, a case that the sampling component completely fails and cannot continue to work is not involved because in this case, the sampling abnormality can be directly recognized based on whether there is sampled data.

Herein, the sampled data relates to any type of sampled data carrying status information of the traction battery. For example, the sampled data can relate to sampled data carrying overall information about the traction battery used as a whole, or relate to sampled data carrying information about any level of component (for example, module, each cell, or a set of cells) of the traction battery, particularly carrying cell information about a specific cell. The sampled data can optionally carry voltage information, temperature information, or current information. In other words, the sampled data may be directly acquired voltage data, current data, or temperature data of an object to be detected (for example, the traction battery as a whole or a specific cell of the traction battery). In addition, it should be noted that the "fluctuation value between the sampled data at adjacent moments" defined above relates to a same type of data of a same object to be detected and should be understood as, if the sampled data is, for example, voltage data of a specific cell, a difference between a voltage value of the cell at a (t+1)^{th} moment and a voltage value at a t^{th} moment in the preset time window or an absolute value of the difference.

The fluctuation value used herein relates to only one object to be detected or a same object to be detected, for example, a same cell numbered as "n". In addition, a recognition process relates to longitudinal comparison of the sampled data over time. For example, the fluctuation value relates to only a voltage difference of a specific cell at different moments, and does not relate to horizontal comparison between this cell and another cell. It is conceivable that if the another cell fails, for example, resistance of the another cell changes, a voltage value of the another cell that can be directly measured by the BMS may change, and in this case, if obtained voltage data is compared with the voltage data of the another cell, a failure of the another cell may be indirectly reflected in recognition accuracy of the specific cell, and the recognition accuracy may be reduced. In contrast, according to the disclosure, on the premise of only longitudinal comparison, a voltage fluctuation degree of the cell essentially reflects a hardware defect of a sampling apparatus (that is, reflects a sampling abnormality of the BMS of the traction battery) in the preset time window, and the voltage fluctuation degree is substantially not affected by a change in a status of the cell.

In addition, when the sampled data relates to cell information about a specific cell, each cell can be traversed through such a sampling abnormality recognition process, so as to obtain a specific position at which the sampling abnormality occurs in the sampling hardware.

Further, according to the disclosure, using the sampled data in the preset time window instead of recognizing a sampling abnormality of the traction battery based on horizontal comparison at a specific moment eliminates occasionality caused by an excessively short time, and implements statistical observation of sampled data of a same object to be detected, so that sampling abnormality recognition accuracy can be further improved. In practice, a time span of the preset time window is optionally designed based on a working status of the traction battery. The working status relates to a charging state, a discharging state, or a rest state. In the rest state, the traction battery is not or is substantially not discharged or charged. For a vehicle assembled with the traction battery, in the rest state, a starter or another component is mainly powered by another additional power supply with a low battery capacity. Herein, the working status of the traction battery can further be correspondingly extended to a working status of the vehicle.

Optionally, a preset time window in the charging state or the discharging state of the traction battery is set to be smaller than that in the rest state of the traction battery. This is mainly for the following reason: for example, a cell voltage of the traction battery changes fast in the charging/discharging state, and high recognition accuracy can be achieved based on sampled data within a short time range. In contrast, in the rest state, considering that the cell voltage or another parameter changes gently, a span of the preset time window in the rest state can be designed to be large. For example, for a traction battery in the charging state, the preset time window is set to one minute, and for a traction battery in the rest state, the preset time window is set to five minutes. The preset time window is set based on the working status of the traction battery, so that a data processing load and the sampling abnormality recognition accuracy can be balanced. Correspondingly, the traction battery sampling abnormality recognition apparatus according to the disclosure further includes a time window determining module 150 configured to set the preset time window in the manner described above, and transmit the preset time window to the data obtaining module 110 in a manner of a signal.

Certainly, the preset time window can be designed to be the same. The preset time window is suitable for any working status of the traction battery, and can be set to an average value by experience. The determined preset time window can be directly entered in the data obtaining module or stored in the time window determining module 150.

In a feasible embodiment, sampled data of the traction battery in a specific determined working state can be obtained by using the data obtaining module 110. In this case, the preset time window is set to a fixed time span, and the probability threshold is also set to a fixed value and is stored in the determining module 130. Specifically, before step S 1, the sampled data is pre-filtered and cleaned to obtain sampled data of the traction battery in a specified working state within a specific time span, and a sampling abnormality is recognized subsequently based on the sampled data.

In another feasible embodiment, sampled data in any time period can be obtained in real time, and the preset time window and the probability threshold can be determined based on a working status of the traction battery at this time. The preset time window can be set in the manner described above, and the probability threshold relates to a statistical probability threshold. Correspondingly, the traction battery sampling abnormality recognition apparatus 100 includes a probability threshold determining module 140 communicatively connected to the determining module 130, so as to transmit, to the determining module 130, the probability threshold determined by using a statistical method.

It should be noted herein that the "probability threshold determined by using the statistical method" can be understood as follows: when the sampled data carries cell information about a specific cell, the probability threshold is obtained by calculating an average value of probabilities, characterizing fluctuation degrees, of historical sampled data of the cell in a same working state, or is obtained by calculating an average value of probabilities, defined by using the above method, of cells of a plurality of (particularly a large number of) traction batteries of a same type. In other words, the probability threshold relates to historical sampled data of the object to be detected, or relates to a same type of reference sampled data of the object to be detected. When the sampled data obtained in step S1 relates to the overall information of the traction battery, the probability threshold can be calculated based on historical sampled data of the traction battery or reference data of a plurality of (particularly a large number of) reference traction batteries of a same type, particularly obtained by calculating an average value or a weighted average value. It should be understood herein that the sampled data and matched historical sampled data or reference sampled data relate to a same type of data.

Optionally, an obtaining process and a processing process of the historical sampled data and the reference sampled data that are used for determining the probability threshold can be performed on any device capable of satisfying a calculation condition. When the traction battery sampling abnormality recognition apparatus 100 is integrated to the vehicle, if a calculation load allows, the probability threshold determining module 140 calls the historical sampled data or the reference sampled data from the cloud, and then processes the historical sampled data or the reference sampled data at the vehicle. Certainly, such a data processing process can alternatively be performed at the cloud close to a data source, and then the processed historical sampled data or reference sampled data is transmitted to and stored in the probability threshold determining module 140.

In another optional implementation, the traction battery sampling abnormality recognition apparatus 100 can be disposed in a battery swap station according to the disclosure, and the battery swap station can obtain corresponding historical sampled data from the cloud or the vehicle. If the reference sampled data relates to the cell information, the battery swap station, particularly the probability threshold determining module 140, can call the reference sampled data from the cloud or the vehicle. If the reference sampling relates to the overall information of the traction battery used as a whole, the battery swap station, particularly the probability threshold determining module 140, can not only obtain reference sampled data from the cloud, particularly the cloud belonging to the battery swap station, but also directly call related reference sampled data from a control system of the battery swap station, and such reference sampled data can relate to historical order information processed by the battery swap station, that is, relate to a traction battery (that is, a reference traction battery) on which a battery charging or swap operation is already performed in the battery swap station. Generally, when the battery charging or swap operation is performed on the traction battery in the battery swap station, related data of the traction battery may be stored in a storage unit of the battery swap station. The storage unit is disposed in the control system of the battery swap station or the cloud of the battery swap station. Using the related data ensures diversity of the reference sampled data for the probability threshold determining process, and improves reliability of the probability threshold, so that traction battery sampling abnormality recognition accuracy is further improved.

Optionally, the traction battery abnormality recognition apparatus 100 further includes an early warning module 160 that is communicatively connected to the determining module 130 and optionally sends an early warning signal based on a received determining result. The early warning signal may be directly displayed to a driver or transmitted to a vehicle control unit in a manner of a signal, or can alternatively be provided for the control system of the battery swap station in a manner of a signal such that maintenance personnel of the battery swap station perform overhauling in time. Specifically, for the battery swap station, if the sampling abnormality of the traction battery can be learned in time or in advance, overcharge caused by an information loss or an information error can be avoided, so that operational safety can be improved. After receiving the early warning signal, the maintenance personnel can take the following measures to ensure safety of the traction battery and the vehicle, for example, limiting charging of the battery, limiting a service of the traction battery, or performing manual intervention or maintenance. Herein, early warning and disposal can be performed on the traction battery in time by full use of real-time automatic interaction between the battery swap station and the traction battery section, so that battery operation and maintenance efficiency is improved.

Correspondingly, the traction battery sampling abnormality recognition method according to the disclosure further includes step S5: if the determining module determines that the traction battery has a sampling abnormality, sending an early warning signal, where the early warning signal is displayed to a driver, a vehicle control unit, or the control system of the battery swap station described below, particularly the maintenance personnel of the battery swap station.

Finally, the disclosure further provides a battery swap station for performing a battery charging and swap operation on a traction battery. The above traction battery sampling recognition apparatus is disposed in the battery swap station. Alternatively, the battery swap station can perform the above sampling abnormality recognition method for a traction battery of a vehicle. With respect to the battery swap station according to the disclosure, reference can be made to descriptions about the traction battery sampling abnormality recognition apparatus and the traction battery sampling abnormality recognition method according to the disclosure, and details are not described herein again.

In summary, based on longitudinal comparison between the sampled data of the traction battery over time, impact of an external factor can be reduced, and abnormality recognition accuracy can be improved accordingly. In an implementation of the disclosure, the preset time window is set based on the working status of the traction battery, so that a data processing load and the sampling abnormality recognition accuracy can be balanced. In another implementation of the disclosure, the sampled data may relate to different types of sampled data at any level of the traction battery, so that applicability of the traction battery sampling abnormality recognition apparatus and method according to the disclosure can be improved. In another implementation of the disclosure, the traction battery sampling abnormality recognition apparatus is disposed in the battery swap station, and the maintenance personnel of the battery swap station are notified in time through the early warning module, so that safety problems caused by an information loss or an information error can be solved. In another implementation of the disclosure, early warning and disposal can be performed on the battery in time through real-time interaction between the battery swap station and the traction battery, so that the battery operation and maintenance efficiency and safety can be improved. In another implementation of the disclosure, the historical sampled data or the reference sampled data is used when the probability threshold is determined, that is, current data is combined with historical data, so that the sampling abnormality can be recognized in an early stage.

It should be understood that all of the above preferred embodiments are exemplary rather than limiting, and any modification or variation made by those skilled in the art to the specific embodiments described above without departing from the concept of the disclosure shall fall within the scope of legal protection of the disclosure.

## Claims

1. A traction battery sampling abnormality recognition apparatus, comprising the following modules communicatively connected:
a data obtaining module configured to obtain sampled data of a traction battery in a preset time window;
a probability calculation module configured to obtain a fluctuation value between sampled data at adjacent moments, and calculate a probability of occurrence of a fluctuation value greater than a preset fluctuation value threshold in the preset time window; and
a determining module configured to determine, based on the probability, whether the traction battery has a sampling abnormality, wherein if the probability is greater than a preset probability threshold, or the probability is less than the probability threshold and a change rate of the probability over time is greater than a preset change rate threshold, the determining module determines that the traction battery has a sampling abnormality.

2. The traction battery sampling abnormality recognition apparatus according to claim 1, wherein the apparatus further comprises a probability threshold determining module configured to determine the probability threshold by using a statistical method, and transmit the probability threshold to the determining module.

3. The traction battery sampling abnormality recognition apparatus according to claim 2, wherein the probability threshold determining module is configured to call historical sampled data of the traction battery, and determine the probability threshold based on the historical sampled data, or the probability threshold determining module is configured to call reference sampled data of a reference traction battery of a same type, and determine the probability threshold based on the reference sampled data.

4. The traction battery sampling abnormality recognition apparatus according to claim 3, wherein the sampled data obtained by the data obtaining module carries overall information about the traction battery used as a whole or cell information about a cell of the traction battery.

5. The traction battery sampling abnormality recognition apparatus according to any one of claims 1 to 4, wherein the apparatus further comprises a time window determining module configured to determine the preset time window based on a working status of the traction battery, and transmit the determined preset time window to the data obtaining module in a manner of a signal.

6. The traction battery sampling abnormality recognition apparatus according to claim 5, wherein the time window determining module is configured to set a preset time window in a charging/discharging state of the traction battery to be smaller than that in a rest state of the traction battery.

7. The traction battery sampling abnormality recognition apparatus according to any one of claims 1 to 6, wherein the sampled data carries voltage information, temperature information, or current information.

8. The traction battery sampling abnormality recognition apparatus according to any one of claims 1 to 7, wherein the apparatus further comprises an early warning module that is communicatively connected to the determining module and correspondingly sends an early warning signal when it is determined that the traction battery has a sampling abnormality.

9. A traction battery sampling abnormality recognition method, executable by a traction battery sampling abnormality recognition apparatus according to any one of claims 1 to 8, the method comprising steps of:
obtaining sampled data of a traction battery in a preset time window;
obtaining a fluctuation value between sampled data at adjacent moments in the preset time window, and calculating a probability of occurrence of a fluctuation value greater than a fluctuation value threshold in the preset time window; and
in response to the probability being greater than a probability threshold, or in response to the probability being less than the probability threshold and a change rate of the probability over time being greater than a change rate threshold, determining that the traction battery has a sampling abnormality.

10. The traction battery sampling abnormality recognition method according to claim 9, wherein the probability threshold is obtained based on historical sampled data or reference sampled data by using a statistical method.

11. The traction battery sampling abnormality recognition method according to claim 9 or 10, wherein the preset time window is set based on a working status of the traction battery, and a preset time window in a charging/discharging state of the traction battery is smaller than that in a rest state of the traction battery.

12. A battery swap station, configured to perform a battery charging and swap operation on a traction battery, wherein a traction battery sampling abnormality recognition apparatus according to any one of claims 1 to 8 is disposed in the battery swap station or a cloud belonging to the battery swap station.

13. The battery swap station according to claim 12, wherein the battery swap station comprises a storage unit configured to store related information of a traction battery already served, and the traction battery sampling abnormality recognition apparatus is capable of calling the related information as reference sampled data.
